# EUROPEAN PATENT SPECIFICATION

(11) **EP 4 576 806 B1**
(45) Date of publication and mention of the grant of the patent: **21.01.2026**
(21) Application number: 23307382.4
(22) Date of filing: 22.12.2023
(51) Int. Cl.: H04Q 1/06, H05K 7/14

(54) **RACK ASSEMBLY FOR A DATA CENTER**
GESTELLANORDNUNG FÜR EIN DATENZENTRUM
ENSEMBLE BÂTI POUR CENTRE DE DONNÉES

(43) Date of publication of application: 25.06.2025
(73) Proprietor: OVH, 59100 Roubaix (FR)
(72) Inventor: THIBAUT, Christophe Maurice, 59139 Noyelles-lès-Seclin (FR); KLABA, Miroslaw Piotr, 59100 Roubaix (FR)
(74) Representative: BCF Global

(56) References cited:
- US-A1- 2015 075 856
- US-A1- 2020 163 256
- US-B1- 6 870 095
- US-B2- 7 178 679

## Description

### FIELD OF TECHNOLOGY

The present technology relates to rack assemblies for data centers.

### BACKGROUND

Data centers house computer equipment and the components associated with the computer equipment, such as servers, their power distribution systems and cables, their monitoring systems, and their network cables. As reliance on computer equipment grows, there is increasing storage demand on data centers. Typically, within a data center, the computer equipment and the associated components are stored in rack assemblies.

Furthermore, the rack assemblies must also accommodate heat management systems for cooling the stored computer equipment that generates significant amounts of heat. Different types of heat management solutions are available, for example, computer room air handlers, in-row air handlers, fans, and water cooling blocks. Each of these heat management systems also have associated components, such as electrical cables, monitoring equipment, and fluid pipes, etc., that must also be stored in the racks or close to the computer equipment in the racks.

Confounding the above considerations is a size and weight limit of the rack assemblies, as well as accessibility needs to the computer equipment and the associated components for maintenance, repair, removal, etc.

There is therefore a desire for a rack assembly for a data center which can alleviate at least some of these drawbacks An example of a rack assembly comprising a frame which defines at least one housing unit provided with a container inserted in a channel, from where the cables can slide in the housing, is disclosed by the document US2020/163256, Chehade et Al, published on 21 May 2020.

### SUMMARY

It is an object of the present technology to ameliorate at least some of the inconveniences present in the prior art.

Developers have identified that a solution for increased storage capability of a rack assembly should operate within the existing external dimensions of rack assemblies. This would allow such increased storage capacity rack assemblies to be used alongside existing rack assemblies without requiring a re-design of a floor map of a data center. Furthermore, in the case of stackable rack assemblies, maintaining the same external dimensions as existing rack assemblies would also enable them to be stacked together.

For example, in an existing rack assembly, Developers considered the challenge of housing three items of computer equipment, each 534 mm and length (total 1600 mm) into a 1940 mm space within a rack assembly. The available 340 mm of space was not large enough to house all the associated components.

Broadly, the present technology provides a rack assembly for a data center in which one or more support members of the rack assembly are used as a storage space for components associated with the computer equipment stored in the rack assembly. More specifically, the horizontal support members (transversely or longitudinally extending) and/or vertical support members are adapted to house containers which in turn house some of the associated components of the computer equipment, such as power distribution systems, cooling systems, controlling systems and network cables.

Advantageously, implementations of the present technology provide rack assemblies which increase a storage space without increasing external dimensions of the rack assembly. This can permit rack assemblies of the present technology to be used in data centers with other rack assemblies with similar dimensions. Furthermore, in certain implementations, the rack assemblies permit the associated components of the stored computer equipment to be stored in a manner that permits easy accessibility for maintenance, repair or removal. For example, access portions to the containers in the rack assemblies can be provided at a front side of the rack assembly. Furthermore, portions of the associated components can extend along the support members to reach different computer equipment, thereby enabling sharing of certain associated components between adjacent or close by computer equipment in the rack assembly.

According to one aspect of the present technology, there is provided a rack assembly for a data center. The rack assembly a frame defining at least one housing unit for housing computer equipment; the frame comprises at least one support member having a support member wall defining a channel for receiving therein at least one container; and at least one support member opening defined in the support member wall; at least one container configured to be housed in the channel and having: a container wall defining a cavity for housing therein at least one component associated with the computer equipment; at least one container opening defined in the container wall through which a portion of the at least one component can extend therethrough; wherein when the at least one container is received in the channel of the at least one support member, the at least one container opening is disposed relative to the at least one support member opening such that the at least one container opening and the at least one support member opening are communicatively coupled.

In some implementations of the present technology, when the at least one container is received in the channel of the at least one support member, the at least one support member opening and the at least one container opening are aligned with each other.

In some implementations of the present technology, the at least one component comprises at least one of: a cable, an electronic equipment, a fluid flow path, and a power distribution unit.

In some implementations of the present technology, the at least one container opening comprises at least one inlet opening and at least one outlet opening.

In some implementations of the present technology, the at least one container outlet opening comprises a plurality of container outlet openings.

In some implementations of the present technology, the at least one inlet opening and the at least one outlet opening are disposed on different portions of the container wall.

In some implementations of the present technology, the at least one container comprises a plurality of containers disposed in series in the channel.

In some implementations of the present technology, the container wall comprises a container front portion, which will face away from the housing unit when the container is received in the channel of the support member, the at least one inlet opening being defined in the container front portion, and a container back portion, which will face towards the housing unit when the container is received in the channel of the support member, the at least one outlet opening being defined in the container back portion.

In some implementations of the present technology, the at least one support member opening is defined in a portion of the support member wall facing the housing unit.

In some implementations of the present technology, the support member is horizontally disposed and the at least one support member opening is defined in a bottom portion or a side portion of the support member wall.

In some implementations of the present technology, the support member is vertically disposed and the support member opening is defined in a back portion or a side portion of the support member wall.

In some implementations of the present technology, the at least one support member comprises an access portion through which the container can be inserted and removed from the channel.

In some implementations of the present technology, the access portion is at one or both of: an end portion of the support member, and through a longitudinal mouth of the channel of the support member.

According to another aspect of the present technology, there is provided a rack assembly for a data centre, the rack assembly comprising a frame defining at least one housing unit for housing computer equipment, the frame comprising at least one support member having a support member wall defining a channel for receiving therein at least one container for housing therein at least one component associated with the computer equipment; and at least one support member opening defined in the support member wall. The support member is configured such that when the container is received in the channel, the at least one support member opening is communicatively couplable with at least one container opening.

In some implementations of the rack assembly of the present technology, the at least one support member opening is defined in a portion of the support member wall facing the housing unit.

In some implementations of the rack assembly of the present technology, the at least one support member is horizontally disposed and the support member opening is defined in a bottom portion or a side portion of the support member wall.

In some implementations of the rack assembly of the present technology, the at least one support member is vertically disposed and the support member opening is defined in a back portion or a side portion of the support member wall.

In some implementations of the rack assembly of the present technology, the at least one support member comprises an access portion through which the container can be inserted and removed from the channel.

In some implementations of the rack assembly of the present technology, the access portion is at one or both of an end portion of the support member, and through a longitudinal mouth of the channel.

According to another aspect of the present technology, there is provided a container for a rack assembly. The container is receivable in a channel of a support member of the rack assembly. The container has a container wall defining a cavity for housing therein at least one component associated with a computer equipment to be housed in a housing unit of the rack assembly; and at least one container opening defined in the container wall, wherein the container is configured to be received in the channel of the support member, and disposed relative thereto, such that when the at least one container is received in the channel, the at least one container opening is communicatively couplable with at least one support member opening.

In some implementations of the container of the present technology, the at least one container opening comprises at least one inlet opening and at least one outlet opening.

In some implementations of the container of the present technology, the at least one outlet opening comprises a plurality of outlet openings.

In some implementations of the container of the present technology, the at least one inlet opening and the at least one outlet opening are disposed on different portions of the container wall.

In some implementations of the container of the present technology, the container wall comprises a container front portion, which will face away from the housing unit when the container is received in the channel of the support member, the at least one inlet opening being defined in the container front portion, and a container back portion, which will face towards the housing unit when the container is received in the channel of the support member, the at least one outlet opening being defined in the container back portion.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

It must be noted that, as used in this specification and the appended claims, the singular form "a", "an" and "the" include plural referents unless the context clearly dictates otherwise.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 is a top plan view of a plurality of rack assemblies for a data center;
Figure 2 is a perspective view from a side of a rack assembly of the data center of Figure 1 and including horizontal support members for housing respective containers, according to implementations of the present technology;
Figure 3 is a cross-sectional elevation view along the line A-A of the rack assembly of Figure 2 and including the containers housed in the horizontal support members, according to implementations of the present technology;
Figure 4A is a close-up perspective view of a portion of one of the horizontal support member of Figure 3, in which the container is disposed in the horizontal support member;
Figure 4B is the close-up perspective view of the portion of the horizontal support member of Figure 4A, in which the container is separated from the horizontal support member;
Figure 4C is the close-up perspective view of Figure 4B in which the container has been rotated to show a bottom portion thereof;
Figure 5 is a front plan view of the portion of the horizontal support member of Figure 4A;
Figure 6 is a close-up perspective view of part of the container housed in the horizontal member of Figure 4A;
Figure 7 is a perspective view of the horizontal support member of Figure 6 with the container removed;
Figure 8 is a perspective view of the container of Figure 6;
Figure 9 is a bottom plan view of the horizontal support member of Figure 2, according to implementations of the present technology;
Figure 10 is a cross-sectional view through the line B-B of Figure 6;
Figure 11 is a side elevation view of the container housed in the horizontal support member of Figure 6;
Figure 12 is a bottom plan view of the horizontal support member of Figure 6 including a bottom portion of the container visible through a support member opening;
Figure 13 is an alternative implementation of the horizontal support member of Figure 7, according to implementations of the present technology;
Figure 14 is an alternative implementation of the container of Figure 8, according to implementations of the present technology;
Figure 15 is a perspective view of another implementation of the rack assembly of the data center of Figure 1 and including longitudinal horizontal support assemblies housing respective containers, according to alternative implementations of the present technology; and
Figure 16 is a perspective view of another implementation of the rack assembly of the data center of Figure 1 and including vertical support assemblies housing respective containers, according to further alternative implementations of the present technology.

### DETAILED DESCRIPTION

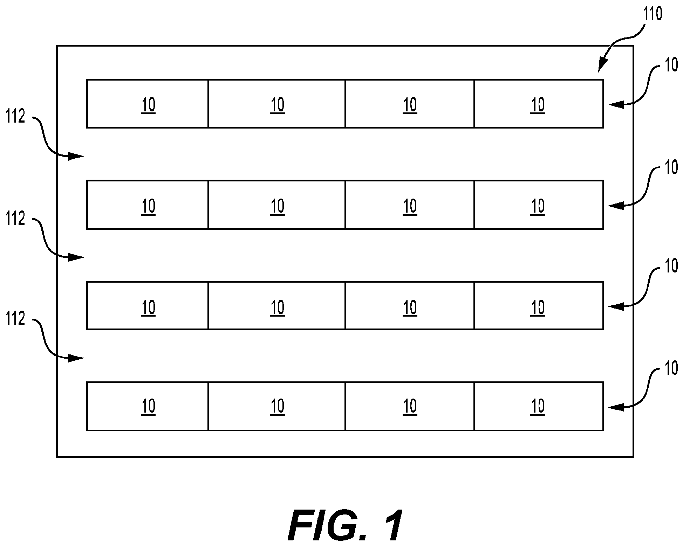

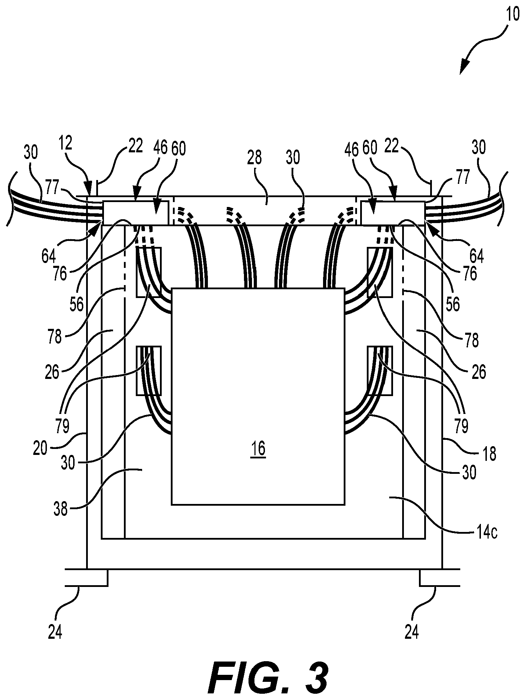

Figure 1 illustrates an exemplary layout of a data center 100 in accordance with an implementation of the present technology. The data center 100 houses multiple rack assemblies 10 in which computer equipment 16 and associated components 30 (Figure 3) can be stored. The rack assemblies 10 are arranged in rows 110 that are spaced apart from one another (forming aisles 112 therebetween) and extend parallel to one another. Each row 110 includes various ones of the rack assemblies 10.

For instance, in this implementation, the computer equipment 16 stored in the rack assemblies 10 includes servers such that the rack assemblies 10 may also be referred to as "server racks". The associated components 30, also referred to as ancillary equipment, may comprise a compact electrical cabinet, power supplies, power distribution units, cooling cables related to heat management systems, monitoring systems, piping, and network cables.

Example heat management systems include fans for promoting air circulation through the computer rack 10, cooling blocks with thermal transfer surfaces for contacting the computer equipment 16 and including fluid distribution piping, and heat exchangers with associated piping and electrical cables, to name a few.

Example monitoring systems may include one or more sensors for monitoring a temperature of the rack or a functioning of the computer equipment 16 housed within the rack 10, and associated electrical cables.

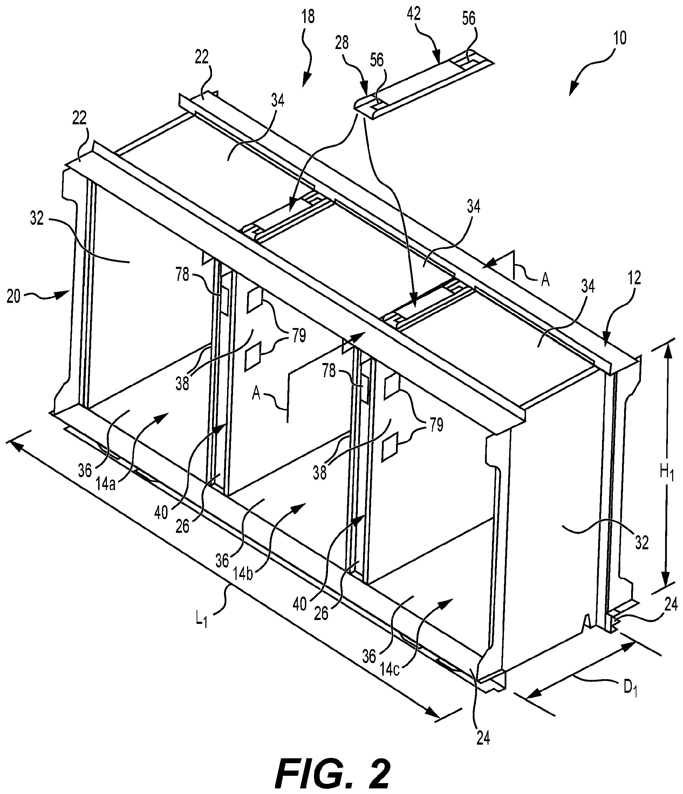

An example of one of the computer racks 10 will now be described with respect to Figures 2 and 3. The rack assembly 10 has a frame 12 defining housing units 14a, 14b, 14c for housing computer equipment 16 therein. The computer rack 10 has a front side 20 through which the computer equipment 16 can be inserted and removed from the computer rack 10, and a rear side 18 opposite the front side 20. In order to dissipate heat generated by the computer equipment 16, air generally enters the computer rack 10 through the front side 20 and exits through the rear side 18. The front side 20 and the rear side 18 may thus be referred to as an air inlet side 20 and an air outlet side18 respectively.

As seen in Figure 2, the rack assembly 10 is generally horizontally-extending which may provide more stability than other types of computer racks that extend vertically. This configuration may also allow stacking racks 10 atop one another. As illustrated, a length L1 of the frame 12, measured horizontally in a longitudinal direction of the frame 12, is greater than a height H1 or depth D1 of the frame 12. For instance, a ratio L1/H1 of the length L1 of the frame 12 over the height H1 of the frame may be between 1.4 and 2.2, in some cases between 1.6 and 2, and in some other cases between 1.8 and 1.9. A ratio L1/D1 of the length L1 of the frame 12 over the depth D1 of the frame may be between 1.4 and1.9, in some cases up to 2.4.

The frame 12 has upper and lower horizontal beams 22, 24 which extend along the length L1 of the rack 10. In the illustrated implementation, there are provided two upper horizontal beams 22 and two lower horizontal beams 24 disposed vertically below and parallel to the upper beams 22. The horizontal beams may have any suitable configuration such as a U-shaped or an L-shaped cross-sectional profile.

The frame 12 is also provided with vertical beams 26 which are fastened (e.g., bolted or welded) to the horizontal beams 22, 24. The vertical beams 26 extend along the height H1 of the rack 10. In the implementation of Figure 2, on the front side 20 there are provided two vertical beams 26 at ends of the rack 10, and two vertical beams positioned inwardly of the vertical beams 26 at the ends. Each of the housing units 14a, 14b, 14c is straddled, in the longitudinal direction of the computer rack 10, by two of the vertical beams 26 such that the housing units 14a, 14b, 14c are arranged horizontally side-by-side. Each vertical beam 26 is aligned, in the longitudinal direction of the rack assembly 10, with another vertical beam 26 that is affixed to an opposite horizontal beam 24. The vertical beams 26 may have any suitable configuration such as a U-shaped or an L-shaped cross-sectional profile. In the implementation of Figure 2, the vertical beams 26 are beams having a generally U-shaped cross-section.

According to certain implementations of the present technology, the frame 12 further comprises horizontal support members 28, which extend transversely to the upper and lower horizontal beams 22, 24 which extend longitudinally. The horizontal support members 28 extend along a depth D1 of the frame 12. The horizontal support members 28 are connected to respective vertical beams 26 and the upper horizontal beams 22. The horizontal support members 28 are configured to house at least a portion of the components 30 of the computer equipment 16 being housed in one or more of the housing units 14a, 14b, 14c, as will be further discussed below.

As best seen in Figure 3, in use, when the computer equipment 16 is housed in the housing unit 14c, the associated components 30 are housed in the horizontal support member 28 and extend from the horizontal support member 28 to the housing unit 14c. In this way, a real estate of the rack assembly 10 may be more efficiently utilised by minimising empty spaces within the rack assembly 10 and without enlarging a footprint of the rack assembly 10. By arranging at least some of the portions of the associated components 30 in the horizontal support members, space can be freed up within the housing units 14a, 14b, 14c for housing, for example, larger computer equipment 16.

As seen in Figure 2, end panels 32 are provided which can be fastened to the ends of each of the upper and lower beams 22, 24 to cover ends of the rack assembly 10. Top panels 34 are provided for covering a top of the rack assembly 10. Floor panels 36 are also provided for providing a support surface for the computer equipment 16. Internal panels 38 are affixed to the vertical beams 26 and extend laterally between laterally-adjacent ones of the vertical beams 26 (i.e., between the vertical beams 26 that are adjacent to one another in the lateral direction of the computer rack 10) to define the housing units 14a, 14b, 14c therebetween. In some instances, the internal panels 38 may comprise the vertical beams 20. Channels 40 are formed between some of the internal panels 38, and may be used to accommodate cables and/or other components associated with operation of computer equipment such as fluid flow paths for cooling. Back panels (not shown) may also be provided on the air outlet side 18 of the computer rack 10.

The computer rack 10 may include doors (not shown). In some implementations, the doors could have fans for promoting air circulation through the computer rack 10. The computer rack 10 may also include various structural components for supporting one or more heat exchangers, or one or more fans. In some implementations, the rack assembly may comprise one or more protective grills disposed on a side of the frame 12 to protect the computer equipment 25 from debris.

The various components of the frame 12 described above are sheet metal components. Nevertheless, it is contemplated that one or more of these components could be made differently in other implementations.

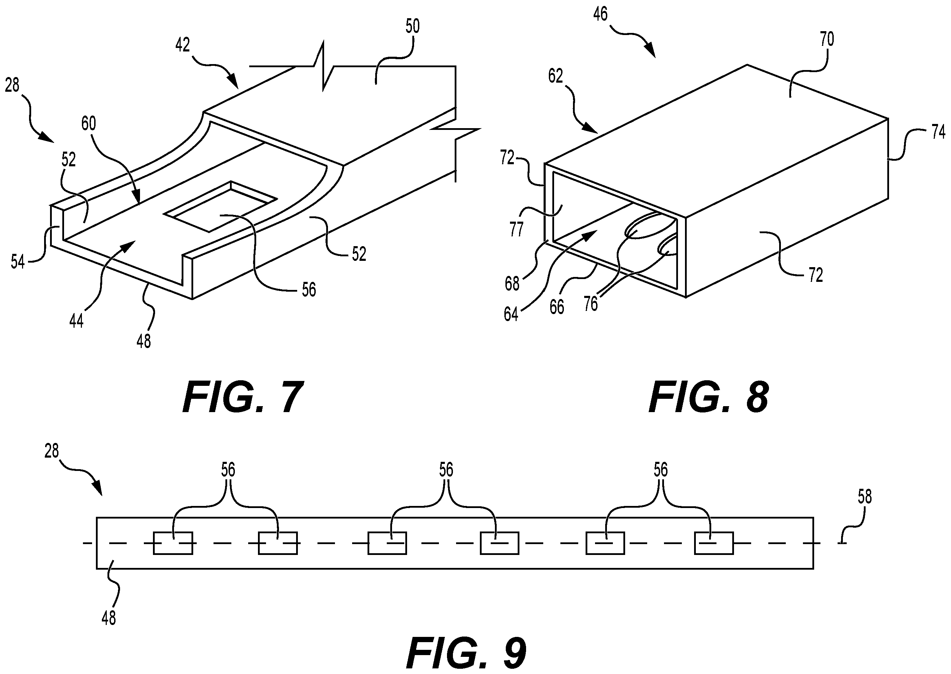

The horizontal support member 28 will now be described with specific reference to Figure 7. The horizontal support member 28 comprises a support member wall 42 defining a support member channel 44 for receiving therein the container 46. In some implementations, the channel 44 may be configured to house more than one container 46. The channel 44 may be configured to house the container 46 at any location along the channel 44, such as at an end of the channel 44 or a mid-portion thereof.

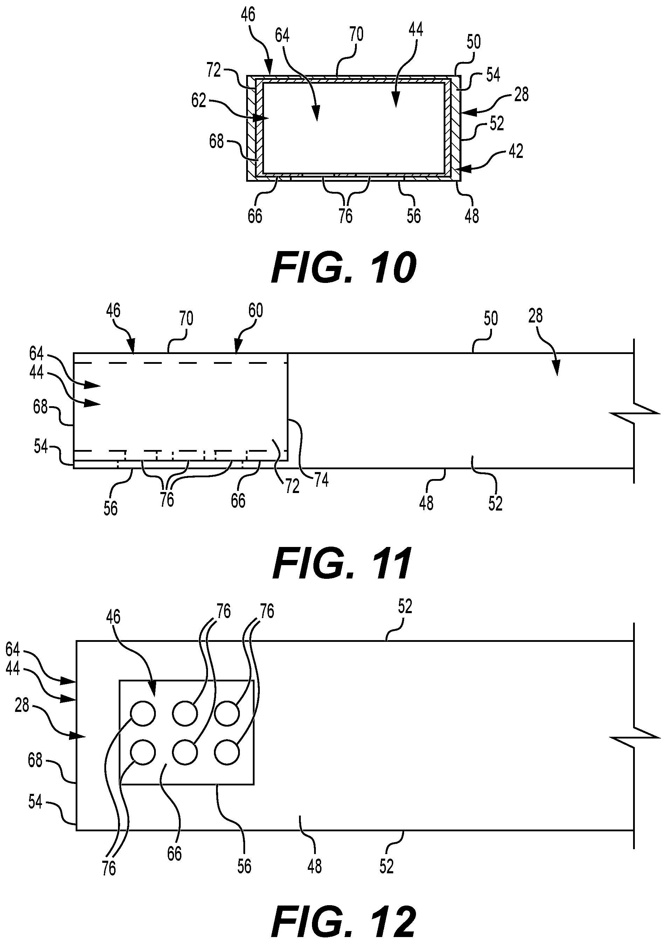

The support member wall 42 has a generally rectangular cross-sectional profile, as best seen in Figures 7 and 10. The container 46 is also generally rectangular in cross-sectional shape as best seen in Figures 7 and 8. In other implementations, the cross-sectional profile of the channel 44 may be any other shape such as rounded, elliptical, U-shaped, etc. The cross-sectional profile of the container 46 may be any other shape and conform to the cross-sectional profile of the channel 44.

The support member wall 42 includes a bottom portion 48, a top portion 50, two side portions 52 and end portions 54. The bottom portion 48 and one of the side portions 52 of the support member 28 faces the housing units 14a, 14b, 14c.

A support member opening 56 is defined in the support member wall 42, specifically in the bottom portion 48. The support member opening 56 is sized and shaped so that components 30 associated with the computer equipment 16, such as cables and tubes, can extend through the support member opening 56 to one or more of the housing units 14a, 14b, 14c housing the computer equipment 16. In the implementation of the horizontal support member 28 illustrated in Figures 3 to 7, the support member opening 56 has a rectangular shape. Any other suitable shape or location of the support member opening 56 is within the scope of the present technology. For example, the support member opening 56 may be elongate and extend longitudinally along the bottom portion 44 of the support member wall 48.

In some implementations, as shown in Figure 9, the horizontal support member 28 is provided with a plurality of support member openings 56 in the bottom portion 48 thereof. This can enable multiple containers 46 to be housed within the horizontal support member 28 or provide a plurality of positions of one container 46 in the horizontal support member 28, each of which can be aligned with a respective support member opening 56 of the horizontal support member 28. The support member openings 56 are spaced from one another along a longitudinal axis 58 of the horizontal support member 28. Any other number, location or spacing of the support member openings 56 are within the scope of the present technology.

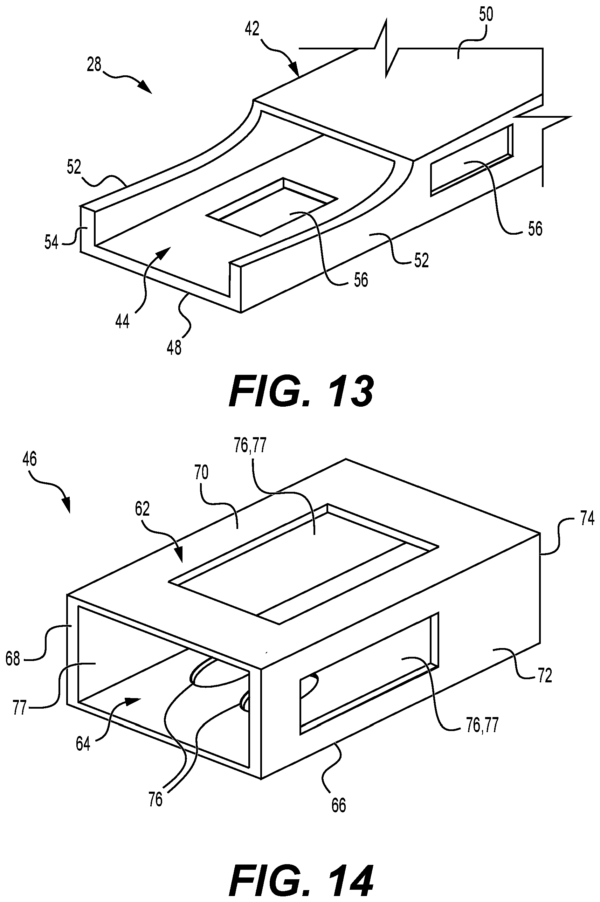

In yet other implementations, as shown in Figure 13, the horizontal support member 28 may be provided with more than one support member opening 56, such as two support member openings. One of the support member openings 56 may be defined in the bottom portion 48 and the other support member opening 56 may be defined in the side portion 52 of the support member wall 42 and/or the top portion 50 of the support member wall 42. This can enable the associated components 30 to extend in different directions towards the housing units 14, 14b, 14c.

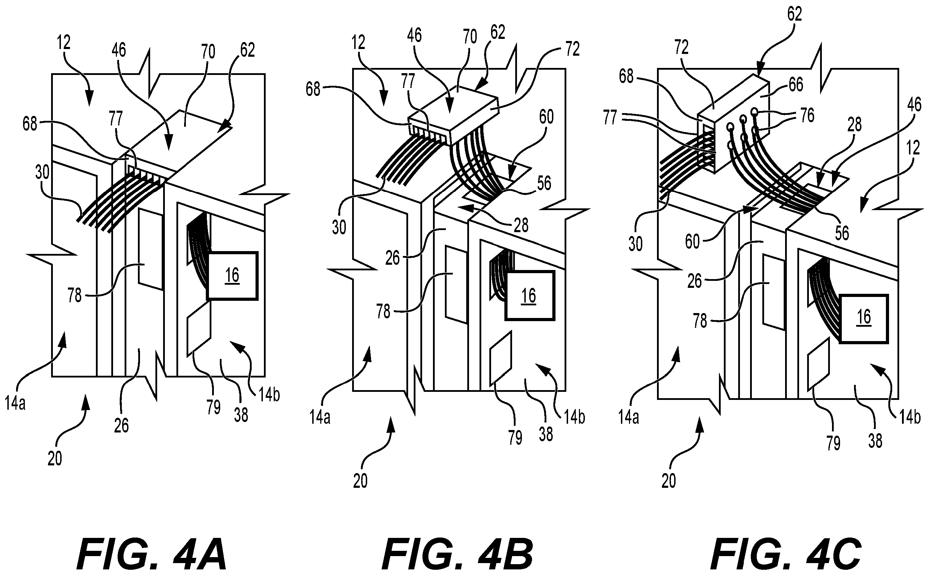

One or both of the end portions 54 of the horizontal support member 28 may be open. As best seen in Figures 4, 6, 7, and 10, the horizontal support member 28 has an access portion 60 through which the container 46 can be inserted and removed from the channel 44. In some implementations, the access portion 60 comprises the open end portion 54 of the horizontal support member 28 as well as recessed side and top portions 52, 50. In other implementations, (not shown), the access portion 60 comprises the open end portion 54 of the horizontal support member 28, without the side and top portions 52, 50 of the support member wall being recessed. In yet other implementations (not shown), the access portion 60 may be through a recessed top portion 50. In yet other implementations, the access portion 60 may comprise a longitudinal mouth of the channel 44.

The container 46 will now be described with reference to Figures 4, 6, 8 and 10. The container comprises a container wall 62 defining a cavity 64 for housing therein the components 30 associated with the computer equipment 16. The container wall 62 has a generally rectangular cross-sectional profile. Therefore, the cavity 64 is also generally cuboidal in shape. The container wall 62 includes a bottom portion 66, a front portion 68, a top portion 70, side portions 72 and a back portion 74. The bottom portion 66 faces the housing units 14a, 14b, 14c when the container 46 is housed in the horizontal support member 28.

An outlet opening 76 is defined in the container wall 62, specifically in the bottom portion 66. In certain implementations, as shown in Figures 4C, 6, 8, 11 and 12, the container 46 is provided with a plurality of outlet openings 76 in the bottom portion 66 thereof. The plurality of the outlet openings 76 may be arranged as an array. Each outlet opening 76 is sized and shaped so that one or more components 30 associated with the computer equipment 16, such as cables and tubes, can extend through the outlet opening 76 to one or more of the housing units 14a, 14b, 14c housing the computer equipment 16. In the implementation of the container 46 illustrated in Figure 4C, there are six outlet openings 76, each container opening having a circular shape. In the implementation of the container 46 illustrated in Figure 8, there are two outlet openings 76, each having elliptical shape.

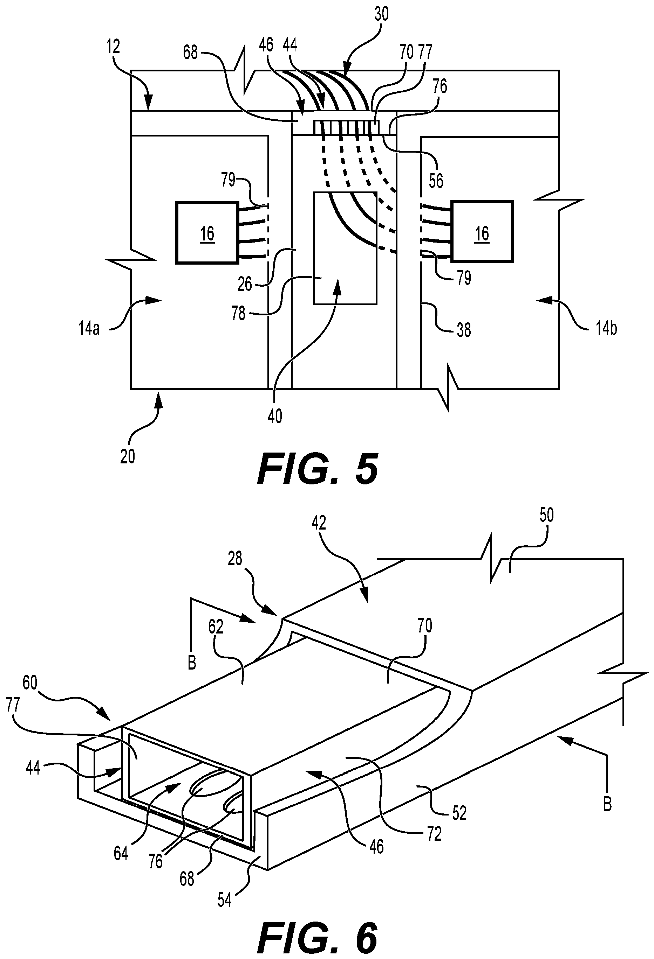

As best seen in Figures 4 and 5, the container 46 is also provided with an inlet opening 77 configured for the components 30 associated with the computer equipment 16 to extend into the container. In this way, the container 46 is configured to house the components 30 associated with the computer equipment 16 and permit their extension in and out of the container 46. The inlet opening 77 may be defined in the front portion 68 of the container wall 62. The inlet opening 77 may comprise ports. Any other number, shape, or location of the inlet opening 77 is within the scope of the present technology. It will be appreciated that, instead of the functions described above, the inlet opening 77 may function as an outlet for the components 30, and the outlet opening 76 may function as an inlet for the components 30.

In yet other implementations, shown in Figures 6 and 8, instead of the inlet opening 77 being defined in the front portion 68 of the container 46, one or both of the ends 68, 74 of the container 46 may be open and thereby function as the inlet opening 77 such that the components 30 can extend through one or both of the open ends 68, 74.

As illustrated in Figures 10, 11 and 12, in use, the support member openings 56 and the outlet opening 76 of the container 46 are aligned such that at least one component 30 of the computer equipment 16 can extend through the aligned openings 56, 76 simultaneously to one or more of the housing units 14a, 14b, and 14c. The inlet opening 77 of the container 46 and the access portion 60 of the support member 28 are also aligned such that at least a portion of the component 30 of the computer equipment 16 can into the container 46.

Figure 14 shows an alternative implementation of the container 46 in which further openings are provided such as in the side, top and bottom portions 72, 70, 66. These additional openings may function as inlet or outlet openings 77, 76. Although the ends 68, 74 of the container 46 is illustrated as being open, they may also be closed.

Referring now to Figures 4 and 5, in certain implementations in which there are panels 38 separating the housing units 14a, 14b, 14c, there may be provided vertical beam openings 78 defined in the vertical beams 26 for the components 30 housed in the horizontal support member 28 to extend through to reach one or more of the housing units 14a, 14b, 14c. Each vertical beam opening 78 is sized and shaped so components 30 associated with the computer equipment 16, such as cables and tubes, can extend therethrough to one or more of the housing units 14a, 14b, 14c housing the computer equipment 16. In the implementation of the vertical beam 26 illustrated in Figures 4 and 5, the vertical beam opening 78 has a rectangular shape. Any other number, shape, or location of the vertical beam openings 78 is within the scope of the present technology.

Referring now to Figures 3, 4 and 5, in certain implementations in which there are panels 32, 34, 36, 38 separating the housing units 14a, 14b, 14c, there may be provided panel openings 79 defined in the panels 32, 34, 36, 38 for the components 30 housed in the horizontal support member 28 to extend through to reach the housing units 14a, 14b, 14c. Each panel opening 79 is sized and shaped so components 30 associated with the computer equipment 16, such as cables and tubes, can extend therethrough to one or more of the housing units 14a, 14b, 14c housing the computer equipment 16. In the implementation of the internal panels 38 illustrated in Figures 3, 4 and 5, the panel openings 79 have a rectangular shape. Any other number, shape, or location of the panel openings 79 is within the scope of the present technology.

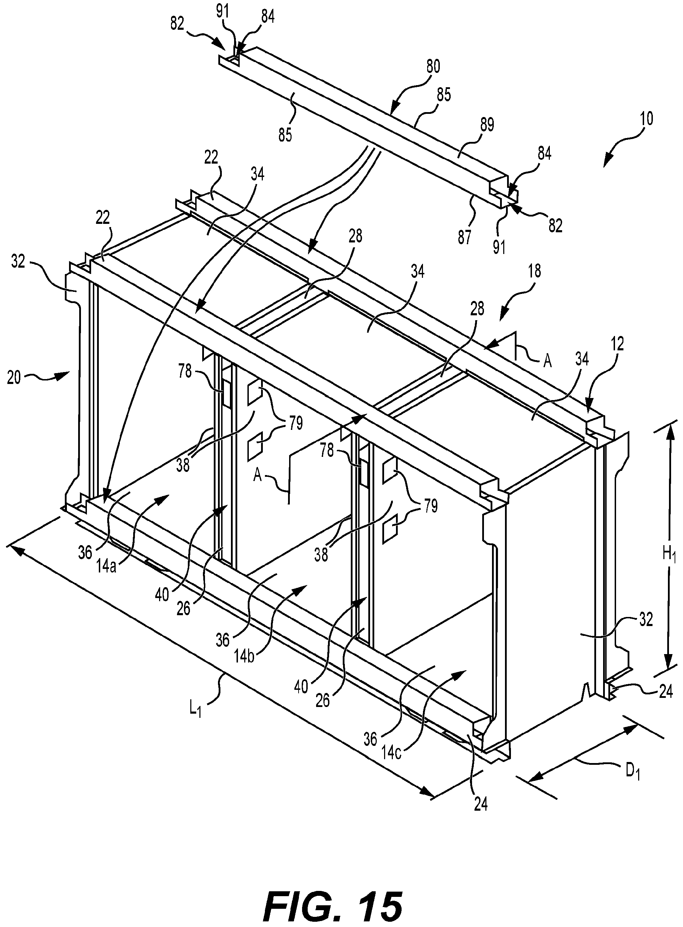

Referring now to Figure 15, in yet other implementations, instead of or in addition to the horizontal support members 28, any combination of the upper and lower horizonal beams 22, 24 may be adapted to conform to the horizontal support member 80. In other words, the horizontal support members 28 may comprise longitudinally extending horizontal support members 80 as well as the transversely extending horizontal support members 28. Similar to the transversely extending horizontal support members 28, the horizontally extending horizontal support members 80 define a channel 82 therein for housing the container 46. An access portion 84 of the horizontal support member 80 may be at a side portion 85, bottom portion 87, top portion 89 or end portion 91 of the adapted horizontal beams 80. When the associated components 30 of the computer equipment 16 are housed in the horizontal support members 80, they extend to the corresponding housing unit 14a, 14b, 14c. This, by utilizing a space inside the horizontal beams 22, 24, a real estate of the rack assembly 10 may be more efficiently utilised.

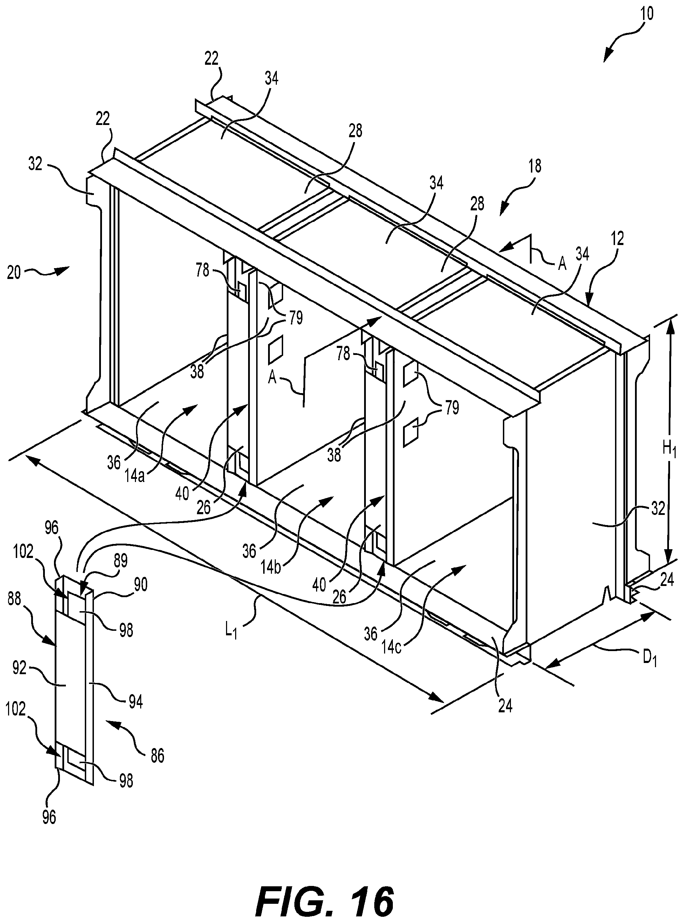

Referring now to Figure 16, in yet other implementations, instead of or in addition to the horizontal support members 28, one or more of the vertical beams 26 may be replaced with vertical support members 86 configured to house the container 46. Similar to the horizontal support member 28, the vertical support member 86 comprises a support member wall 88 defining a channel 89 for receiving therein the container 46. The support member wall 88 and the channel 89 have a generally rectangular cross-section. The vertical support member wall 88 includes a back portion 90, a front portion 92, two side portions 94 and two end portions 96. The back portion 90 faces the housing units 14a, 14b, 14c.

The vertical support member 86 has a vertical support member opening 98 defined in the back portion 90 of the support member wall 88. The vertical support member opening 98 is sized and shaped so that the components 30 associated with the computer equipment 16, such as cables and tubes, can extend through the vertical support member opening 98 to one or more of the housing units 14a, 14b, 14c housing the computer equipment 16.

An additional vertical support member opening 98 is provided as an access portion 102 at an end portion 96 of the support member 86 through which the container 46 can be inserted and removed from the channel 89. In some implementations, the access portion 102 comprises the open end portion 96 of the support member 86 as well as recessed side and front portions 94, 92. In other implementations, the access portion 102 comprises the open end portion 96 of the vertical support member 86, without the side and front portions 94, 92 of the support member wall 88 being recessed.

When the container 46 is housed in the channel 89 of the vertical support member 86, the vertical support member opening 98 is aligned with the container opening 76. The associated components 30 of the computer equipment 16 housed in the vertical support member 86 extend from the vertical support member 86 to the corresponding housing unit 14a, 14b, 14c. By utilizing a space inside the vertical beams 26, a real estate of the rack assembly 10 may be more efficiently utilised.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A rack assembly (10) for a data centre, the rack assembly comprising:
a frame (12) defining at least one housing unit (14a, 14b, 14c) for housing computer equipment (16), the frame (12) comprising:
at least one support member (28) having:
a support member wall (42) defining a channel (44) for receiving therein at least one container (46);
at least one support member opening (56) defined in the support member wall (42);
at least one container (46) configured to be housed in the channel (44) and having:
a container wall (62) defining a cavity (64) for housing therein at least one component (30) associated with the computer equipment (16);
at least one container opening (76) defined in the container wall (62) through which a portion of the at least one component (30) can extend therethrough;
wherein when the at least one container (46) is received in the channel (44) of the at least one support member (28), the at least one container opening (76) is disposed relative to the at least one support member opening (56) such that the at least one container opening (76) and the at least one support member opening (56) are communicatively coupled.

2. The rack assembly (10) of claim 1, wherein when the at least one container (46) is received in the channel (44) of the at least one support member (28), the at least one support member opening (56) and the at least one container opening (76) are aligned with each other.

3. The rack assembly (10) of claim 1 or 2, wherein the at least one component (30) comprises at least one of: a cable, a hard drive, a fluid flow path, and a power distribution unit.

4. The rack assembly (10) of any one of claims 1 to 3, wherein the at least one container opening (76) comprises at least one inlet opening and at least one outlet opening.

5. The rack assembly (10) of claim 4, wherein the at least one outlet opening comprises a plurality of outlet openings.

6. The rack assembly (10) of claim 4 or 5, wherein the at least one inlet opening and the at least one outlet opening are disposed on different portions of the container wall (62).

7. The rack assembly (10) of any one of claims 1 to 6, wherein the at least one container (46) comprises a plurality of containers disposed in series in the channel.

8. The rack assembly (10) of any one of claims 1 to 7, wherein the container wall (62) comprises:
a container front portion (68), which will face away from the housing unit (14a, 14b, 14c) when the container (46) is received in the channel (44) of the support member (28), the at least one inlet opening being defined in the container front portion (68), and
a container back portion (74), which will face towards the housing unit (14a, 14b, 14c) when the container (46) is received in the channel (44) of the support member (28), the at least one outlet opening being defined in the container back portion (74).

9. The rack assembly (10) of any one of claims 1 to 8, wherein the at least one support member opening (56) is defined in a portion of the support member wall (42) facing the housing unit (14a, 14b, 14c).

10. The rack assembly (10) of any one of claims 1 to 9, wherein the support member (28) is horizontally disposed and the at least one support member opening (56) is defined in a bottom portion (48) or a side portion (52) of the support member wall (42).

11. The rack assembly (10) of any one of claims 1 to 9, wherein the support member (86) is vertically disposed and the support member opening (98) is defined in a back portion (90) or a side portion (94) of the support member wall (88).

12. The rack assembly (10) of any one of claims 1 to 11, wherein the at least one support member (28, 86) comprises an access portion (60, 102) through which the container (46) can be inserted and removed from the channel (44, 82).

13. The rack assembly (10) of claim 12, wherein the access portion (60, 102) is at one or both of: an end portion (54, 96) of the support member (28, 86), and through a longitudinal mouth of the channel of the support member.

## Patentansprüche

1. Rack-Anordnung (10) für ein Rechenzentrum, wobei die Rack-Anordnung umfasst:
einen Rahmen (12), der mindestens eine Gehäuseeinheit (14a, 14b, 14c) zum Unterbringen von Computerausrüstung (16) definiert, wobei der Rahmen (12) umfasst:
mindestens ein Trägerelement (28) mit:
einer Trägerelementwand (42), die einen Kanal (44) zum Aufnehmen mindestens eines Behälters (46) darin definiert;
mindestens einer Trägerelementöffnung (56), die in der Trägerelementwand (42) definiert ist;
mindestens einem Behälter (46), der eingerichtet ist, um in dem Kanal (44) untergebracht zu sein, und mit:
einer Behälterwand (62), die einen Hohlraum (64) zum Unterbringen mindestens einer Komponente (30) darin definiert, die mit der Computerausrüstung (16) verbunden ist;
mindestens einer Behälteröffnung (76), die in der Behälterwand (62) definiert ist, durch die sich ein Abschnitt der mindestens einen Komponente (30) hindurch erstrecken kann;
wobei, wenn der mindestens eine Behälter (46) in dem Kanal (44) des mindestens einen Trägerelements (28) aufgenommen ist, die mindestens eine Behälteröffnung (76) relativ zu der mindestens einen Trägerelementöffnung (56) derart angeordnet ist, dass die mindestens eine Behälteröffnung (76) und die mindestens eine Trägerelementöffnung (56) kommunikativ gekoppelt sind.

2. Rack-Anordnung (10) nach Anspruch 1, wobei, wenn der mindestens eine Behälter (46) in dem Kanal (44) des mindestens einen Trägerelements (28) aufgenommen ist, die mindestens einen Trägerelementöffnung (56) und die mindestens eine Behälteröffnung (76) miteinander ausgerichtet sind.

3. Rack-Anordnung (10) nach Anspruch 1 oder 2, wobei die mindestens eine Komponente (30) mindestens eines umfasst von: einem Kabel, einer Festplatte, einem Fluidströmungspfad und einer Stromverteilungseinheit.

4. Rack-Anordnung (10) nach einem der Ansprüche 1 bis 3, wobei die mindestens eine Behälteröffnung (76) mindestens eine Einlassöffnung und mindestens eine Auslassöffnung umfasst.

5. Rack-Anordnung (10) nach Anspruch 4, wobei die mindestens eine Auslassöffnung eine Vielzahl von Auslassöffnungen umfasst.

6. Rack-Anordnung (10) nach Anspruch 4 oder 5, wobei die mindestens eine Einlassöffnung und die mindestens eine Auslassöffnung auf verschiedenen Abschnitten der Behälterwand (62) angeordnet sind.

7. Rack-Anordnung (10) nach einem der Ansprüche 1 bis 6, wobei der mindestens eine Behälter (46) eine Vielzahl von Behältern umfasst, die in Reihe in dem Kanal angeordnet sind.

8. Rack-Anordnung (10) nach einem der Ansprüche 1 bis 7, wobei die Behälterwand (62) umfasst:
einen Behältervorderabschnitt (68), der von der Gehäuseeinheit (14a, 14b, 14c) weg zeigt, wenn der Behälter (46) in dem Kanal (44) des Trägerelements (28) aufgenommen ist, wobei die mindestens eine Einlassöffnung in dem Behältervorderabschnitt (68) definiert ist, und
einen Behälterrückabschnitt (74), der zu der Gehäuseeinheit (14a, 14b, 14c) hin zeigt, wenn der Behälter (46) in dem Kanal (44) des Trägerelements (28) aufgenommen ist, wobei die mindestens eine Auslassöffnung in dem Behälterrückabschnitt (74) definiert ist.

9. Rack-Anordnung (10) nach einem der Ansprüche 1 bis 8, wobei die mindestens eine Trägerelementöffnung (56) in einem Abschnitt der Trägerelementwand (42) definiert ist, der der Gehäuseeinheit (14a, 14b, 14c) zugewandt ist.

10. Rack-Anordnung (10) nach einem der Ansprüche 1 bis 9, wobei das Trägerelement (28) horizontal angeordnet ist und die mindestens eine Trägerelementöffnung (56) in einem unteren Abschnitt (48) oder einem seitlichen Abschnitt (52) der Trägerelementwand (42) definiert ist.

11. Rack-Anordnung (10) nach einem der Ansprüche 1 bis 9, wobei das Trägerelement (86) vertikal angeordnet ist und die Trägerelementöffnung (98) in einem hinteren Abschnitt (90) oder einem seitlichen Abschnitt (94) der Trägerelementwand (88) definiert ist.

12. Rack-Anordnung (10) nach einem der Ansprüche 1 bis 11, wobei das mindestens eine Trägerelement (28, 86) einen Zugangsabschnitt (60, 102) umfasst, durch den der Behälter (46) in den Kanal (44, 82) eingesetzt und wieder daraus entnommen werden kann.

13. Rack-Anordnung (10) nach Anspruch 12, wobei sich der Zugangsabschnitt (60, 102) an einem oder beiden befindet von: einem Endabschnitt (54, 96) des Trägerelements (28, 86) und durch eine Längsmündung des Kanals des Trägerelements.

## Revendications

1. Ensemble bâti (10) pour un centre de données, l'ensemble bâti comprenant :
un cadre (12) définissant au moins une unité de logement (14a, 14b, 14c) destinée à loger un équipement informatique (16), le cadre (12) comprenant :
au moins un élément de support (28) ayant :
une paroi d'élément de support (42) définissant un canal (44) destiné à y recevoir au moins un conteneur (46) ;
au moins une ouverture d'élément de support (56) définie dans la paroi d'élément de support (42) ;
au moins un conteneur (46) configuré pour être logé dans le canal (44) et ayant :
une paroi de conteneur (62) définissant une cavité (64) destinée à y loger au moins un composant (30) associé à l'équipement informatique (16) ;
au moins une ouverture de conteneur (76) définie dans la paroi de conteneur (62) à travers laquelle une partie de l'au moins un composant (30) peut se prolonger ;
dans lequel lorsque l'au moins un conteneur (46) est reçu dans le canal (44) de l'au moins un élément de support (28), l'au moins une ouverture de conteneur (76) est disposée par rapport à l'au moins une ouverture d'élément de support (56) de sorte que l'au moins une ouverture de conteneur (76) et l'au moins une ouverture d'élément de support (56) sont couplées de manière communicative.

2. Ensemble bâti (10) selon la revendication 1, dans lequel lorsque l'au moins un conteneur (46) est reçu dans le canal (44) de l'au moins un élément de support (28), l'au moins une ouverture d'élément de support (56) et l'au moins une ouverture de conteneur (76) sont alignées l'une avec l'autre.

3. Ensemble bâti (10) selon la revendication 1 ou 2, dans lequel l'au moins un composant (30) comprend au moins l'un des éléments suivants : un câble, un disque dur, un chemin d'écoulement de fluide, et une unité de distribution d'alimentation.

4. Ensemble bâti (10) selon l'une quelconque des revendications 1 à 3, dans lequel l'au moins une ouverture de conteneur (76) comprend au moins une ouverture d'entrée et au moins une ouverture de sortie.

5. Ensemble bâti (10) selon la revendication 4, dans lequel l'au moins une ouverture de sortie comprend une pluralité d'ouvertures de sortie.

6. Ensemble bâti (10) selon la revendication 4 ou 5, dans lequel l'au moins une ouverture d'entrée et l'au moins une ouverture de sortie sont disposées sur différentes parties de la paroi de conteneur (62).

7. Ensemble bâti (10) selon l'une quelconque des revendications 1 à 6, dans lequel l'au moins un conteneur (46) comprend une pluralité de conteneurs disposés en série dans le canal.

8. Ensemble bâti (10) selon l'une quelconque des revendications 1 à 7, dans lequel la paroi de conteneur (62) comprend :
une partie avant de conteneur (68), qui sera orientée à l'opposé de l'unité de logement (14a, 14b, 14c) lorsque le conteneur (46) est reçu dans le canal (44) de l'élément de support (28), l'au moins une ouverture d'entrée étant définie dans la partie avant de conteneur (68), et
une partie arrière de conteneur (74), qui sera orientée vers l'unité de logement (14a, 14b, 14c) lorsque le conteneur (46) est reçu dans le canal (44) de l'élément de support (28), l'au moins une ouverture de sortie étant définie dans la partie arrière de conteneur (74).

9. Ensemble bâti (10) selon l'une quelconque des revendications 1 à 8, dans lequel l'au moins une ouverture d'élément de support (56) est définie dans une partie de la paroi d'élément de support (42) faisant face à l'unité de logement (14a, 14b, 14c).

10. Ensemble bâti (10) selon l'une quelconque des revendications 1 à 9, dans lequel l'élément de support (28) est disposé horizontalement et l'au moins une ouverture d'élément de support (56) est définie dans une partie inférieure (48) ou une partie latérale (52) de la paroi d'élément de support (42).

11. Ensemble bâti (10) selon l'une quelconque des revendications 1 à 9, dans lequel l'élément de support (86) est disposé verticalement et l'ouverture d'élément de support (98) est définie dans une partie arrière (90) ou une partie latérale (94) de la paroi d'élément de support (88).

12. Ensemble bâti (10) selon l'une quelconque des revendications 1 à 11, dans lequel l'au moins un élément de support (28, 86) comprend une partie d'accès (60, 102) à travers laquelle le conteneur (46) peut être inséré et retiré du canal (44, 82).

13. Ensemble bâti (10) selon la revendication 12, dans lequel la partie d'accès (60, 102) se situe au niveau de l'une ou des deux zones suivantes : une partie d'extrémité (54, 96) de l'élément de support (28, 86), et à travers une embouchure longitudinale du canal de l'élément de support.
